**Europäisches Patentamt**

**European Patent Office**

**Office européen des brevets**

(19)

(11) Veröffentlichungsnummer: **0 645 831 A1**

(12) **EUROPÄISCHE PATENTANMELDUNG**

(21) Anmeldenummer: **94114629.2**

(22) Anmeldetag: **16.09.94**

(51) Int. Cl.6: **H01L 43/10**

(30) Priorität: **29.09.93 DE 4333180**

(43) Veröffentlichungstag der Anmeldung: **29.03.95 Patentblatt 95/13**

(84) Benannte Vertragsstaaten: **DE FR GB NL**

(71) Anmelder: **SIEMENS AKTIENGESELLSCHAFT Wittelsbacherplatz 2 D-80333 München (DE)**

(72) Erfinder: **von Helmolt,Rittmar,Dipl.-Phys. Donaustrasse 14 D-91052 Erlangen (DE)** Erfinder: **Wecker, Joachim, Dr. Eichenring 29 D-91341 Röttenbach (DE)**

(54) **Magnetoresistiver Sensor unter Verwendung eines Sensormaterials mit perowskitähnlicher Kristallstruktur.**

(57) Der Sensor ist mit Material mit einer perowskitähnlichen Kristallstruktur und einem erhöhten magnetoresistiven Effekt aufgebaut. Das Material basiert auf der Zusammensetzung $(A1)_{1-x}(A2)_xMnO_z$ mit A1 (3-wertig) aus Y, La oder einem Lanthanid, mit A2 (2-wertig) aus einem Erdalkalimetall oder Pb und mit $0,1 \leq x \leq 0,9$ sowie $2,0 \leq z \leq 3,5$. Erfindungsgemäß enthält der Sensor ein Schichtensystem (2) mit mindestens zwei Schichten (3, 4) mit unterschiedlichen Materialien, jedoch jeweils im Rahmen der genannten Zusammensetzung, die so gewählt ist, daß die Temperaturabhängigkeit des elektrischen Widerstandes verhältnismäßig gering ist.Die beiden Schichten des Schichtensystems können auch zu einem einzigen Schichtaufbau mit einem Konzentrationsgradienten vereinigt werden.

FIG 1

EP 0 645 831 A1

Die Erfindung betrifft einen magnetoresistiven Sensor mit einer Schicht aus einem Sensormaterial, das eine perowskitähnliche Kristallstruktur besitzt und einen erhöhten magnetoresistiven Effekt zeigt.

Der allgemeine Aufbau und die Funktionsweise von magnetoresistiven Sensoren mit Dünnfilmen aus ferromagnetischen Übergangsmetallen sind z.B. in dem Buch "Sensors", Vol. 5, 1989, Seiten 341 bis 380 naher erläutert. Die dort offenbarten, weitgehend magnetostriktionsfreien Schichten, die z.B. aus einer speziellen NiFe-Legierung (Permalloy) oder aus einer speziellen NiCo-Legierung bestehen, zeigen jedoch nur einen verhältnismäßig geringen magnetoresistiven Effekt $M_r$ von etwa 2 bis 3 %. Dabei gilt: $M_r = [\ R(0) - R(B)\ ]/R(0)$, wobei $R(B)$ der elektrische Widerstand im Magnetfeld mit der Induktion B und $R(0)$ der Widerstand bei fehlendem Magnetfeld sind. Bisweilen wird der magnetoresistive Effekt auch folgendermaßen definiert:

$$M_r' = [\ R(0) - R(B)\ ]/R(B); \text{ d.h.: } M_r = M_r'\ /\ (1 + M_r').$$

Man ist an einer Erhöhung dieses magnetoresistiven Effektes interessiert, um so Sensoren mit verbessertem Signal-Rausch-Verhältnis realisieren und den Einsatzbereich entsprechender Sensoren erweitern zu können. Eine Erhöhung des magnetoresistiven Effektes konnte bei einigen Mehrschichtsystemen wie z.B. Co/Cu, Co/Ru, Co/Cr oder Fe/Cr nachgewiesen werden (vgl. z.B. "Appl. Phys. Lett.", Vol. 58, No. 23, 10.6.1991, Seiten 2710 bis 2712 oder "Phys. Rev. Lett.", Vol. 64, No. 19, 7.5.1990, Seiten 2304 bis 2307). Hierbei wird von der Tatsache ausgegangen, daß eine nicht-magnetische Zwischenschicht zwischen Schichten aus ferromagnetischem Material eine Austauschkopplung (Austausch-Wechselwirkung) bewirken kann. Diese Kopplung hängt von der Dicke der Zwischenschicht ab und bedingt Dicken im Nanometerbereich. Die Austauschkopplung ist dabei fuhr das magnetische Verhalten ("ferromagnetisch" oder "antiferromagnetisch") des Mehrschichtsystems verantwortlich.

Dementsprechend können Mehrschichtsysteme mit unterschiedlicher Richtung der Polarisation der übereinanderliegenden ferromagnetischen, durch nicht-magnetische Schichten getrennten Einzelschichten einen erhöhten magnetoresistiven Effekt $M_r$ zeigen. Dieser Effekt, der für geschichtete Cu-Co-Dünnfilmstrukturen bei Raumtemperatur bis zu 40 % betragen kann (vgl. die genannte Literaturstelle aus "Appl. Phys. Lett." 58), wird deshalb auch als "Giant magneto resistive effect" (GMR) bezeichnet (vgl. "Phys. Rev. Lett.", Vol. 61, No. 21, 21.11.1988, Seiten 2472 bis 2475).

Die Beschränkung auf Multilagensysteme und die starke Abhängigkeit des Effektes von der sehr geringen Dicke der magnetischen bzw. nicht-magnetischen Schichten im Nanometer-Bereich stellt jedoch hohe Anforderungen an die Präparationstechnik der Schichten und schränkt den Einsatzbereich auf entsprechend Dünnschichtstrukturen ein.

Darüber hinaus sind Untersuchungen bekannt, nach denen ein magnetoresistiver Effekt auch in beispielsweise granularen Stoffsystemen auftreten kann (vgl. "Phys. Rev. Lett.", Vol. 68, No. 25, 1992, Seiten 3745 bis 3752). Gemäß dieser sich auf das Stoffsystem Cu-Co erstreckenden Untersuchungen werden CuCo-Legierungsschichten durch simultanes Zerstäuben der Elemente hergestellt und durch eine anschließende Wärmebehandlung nanokristalline (magnetische) Co-Ausscheidungen in einer (nicht-magnetischen) Cu-Matrix erzeugt. Der in diesen Dünnfilmen zu messende magnetoresistive Effekt $M_r$ beträgt nach der genannten Literaturstelle aus "Phys. Rev. Lett." 68 etwa 7 % bei Raumtemperatur.

Zwar wurden wesentlich größere magnetoresistive Effekte auch bei anderen ferromagnetischen Stoffsystemen beobachtet. Dies trifft für Einkristalle des Stoffsystems $Eu_{1-x}Gd_xSe$ zu (vgl. "Journ. Appl. Phys.", Vol. 38, No. 3, 1.3.1967, Seiten 959 bis 964). Ein entsprechender Effekt zeigt sich auch in $Nd_{0,5}Pb_{0,5}MnO_3$-Kristallen. Diese Kristalle haben eine perowskitähnliche Struktur (vgl. "Physica B", Vol. 155, 1989, Seiten 362 bis 365). Die in diesen Stoffsystemen zu beobachtende Änderung des elektrischen Widerstandes in Abhängigkeit von der magnetischen Induktion ist jedoch auf tiefe Temperaturen beschränkt, die deutlich unter Raumtemperatur liegen.

Diese vorerwähnten Probleme treten nicht oder zumindest nur in vermindertem Umfang bei einem Sensormaterial auf, das Gegenstand der nicht-vorveröffentlichten deutschen Patentanmeldung P 43 10 318.9 ist. Dieses Material besitzt eine perowskitähnliche Kristallstruktur und zeigt einen erhöhten magnetoresistiven Effekt. Dabei soll für das Material eine Zusammensetzung auf Basis von $(A1)_{1-x}(A2)_xMnO_z$ gewählt werden, wobei die dreiwertige Komponente A1 ein Lanthanid einschließlich Lanthan (La) oder Yttrium (Y) und die zweiwertige Komponente A2 ein Erdalkalimetall oder Blei (Pb) zumindest enthalten und $0,1 \leq x \leq 0,9$ sowie $2,0 \leq z \leq 3,5$ sind.

Unter einer Basis der hier genannten Zusammensetzung sei die Grundzusammensetzung mit den vier genannten Komponenten verstanden. Die einzelnen Komponenten stellen dabei Hauptkomponenten dar, die gegebenenfalls durch andere Elemente zu einem geringeren Anteil (unter 50 %), nämlich durch ein anderes Element aus der zu den jeweiligen Komponenten genannten Elementengruppe substituiert sein können. Insbesondere lassen sich z.B. bis zu 35 Atom-% der Mn-Komponente durch ein anderes Metall mit 3d-Elektronenkonfiguration, vorzugsweise auch durch Cu oder durch Al, ersetzen. Für die Zusammensetzung dieser Komponente gilt dann also: $Mn_{1-y}(A3)_y$ mit $0 < y \leq 0,35$. Bei den 3d-Elementen handelt es sich dabei um die Elemente des Periodensystems der Elemente mit den Ordnungszahlen zwischen 21 und 30 (einschließlich). Außerdem können selbstverständlich in dem vorgeschlagenen Material übliche Verunreinigungselemente mit jeweils einem Anteil unter 0,5 Atom-% vorhanden sein. Es wurde erkannt, daß das vorgeschlagene Material einen verhältnismäßig hohen magnetoresistiven Effekt zeigt, so daß es vorteilhaft für magnetoresistive Sensoren vorgesehen wird. Die Curie-Temperatur des Sensormaterials liegt je nach Stöchiometrie der Zusammensetzung etwa bei Raumtemperatur. Bei dieser Temperatur zeigt das Material ebenfalls den erwähnten elektronischen Übergang vom lokalisierten (halbleitenden), unmagnetischen zum metallisch leitenden, magnetischen Zustand (vgl. "Solid State Commun.", Vol. 82, No. 9, 1992, Seiten 693 bis 696). Die formale Mn-Valenz, welche die Leitfähigkeit und die Übergangstemperatur beeinflußt, wird durch die Anteile an der dreiwertigen Al-Komponente und der zweiwertigen A2-Komponente bestimmt. So ergibt sich beispielsweise für die Zusammensetzung $La_{2/3}Ba_{1/3}MnO_3$ unter der Annahme der Valenzen für O = -2, La = +3 und Ba = +2 eine formale Mn-Valenz von 3,33. Für die vorgesehene Verwendung in magnetoresistiven Sensoren ist vorteilhaft ein Anteil von x zwischen 10 und 90 Atom-% bzgl. des Anteils A1 + A2 (= 100 Atom-%). Einen ähnlichen Einfluß hat auch die Substitution des Mn durch andere 3d- oder 4s-Elemente, wobei bis zu 35 Atom-% der Mn-Komponente durch das andere Element ersetzt werden können. Ferner ist ein Sauerstoffgehalt mit $z \approx 3$ als besonders günstig anzusehen.

Besonders vorteilhaft läßt sich das Sensormaterial als Schicht auf einem Substrat durch Laserablation eines entsprechenden Targetmaterials abscheiden. Diese Abscheidung kann beispielsweise "off-axis" erfolgen.

Es zeigt sich jedoch, daß der hohe magnetoresistive Effekt $M_r$ des vorgeschlagenen Materials mit einer verhältnismäßig großen Temperaturabhängigkeit einhergeht, die aus der physikalischen Ursache des Magnetowiderstandes herrührt, der in diesem Fall mit dem ferromagnetischen Übergang gekoppelt ist.

Aufgabe der vorliegenden Erfindung ist es deshalb, den magnetoresistiven Sensor der eingangs genannten Art mit dem vorgeschlagenen Sensormaterial dahingehend auszugestalten, daß diese Temperaturabhängigkeit des magnetoresistiven Effektes verringert ist.

Diese Aufgabe wird erfindungsgemäß dadurch gelöst, daß ein Schichtensystem mit der genannten, ersten Schicht und einer zweiten Schicht aus einem zweiten Material vorgesehen ist, das ebenfalls eine Zusammensetzung auf der genannten Basis aufweist, jedoch hinsichtlich des Anteils und/oder des Elements von mindestens einer seiner Komponenten derart von dem Material der ersten Schicht verschieden ist, daß die Temperaturabhängigkeit des elektrischen Widerstandes des Schichtensystems verringert ist gegenüber der des elektrischen Widerstandes jeder einzelnen Schicht.

Die Temperaturabhängigkeit des elektrischen Widerstandes und damit auch des Magnetowiderstandes wird somit erfindungsgemäß dadurch reduziert, daß verschiedene Materialien mit unterschiedlichen Übergangstemperaturen zu einem Schichtensystem kombiniert werden. Im einfachsten Fall kann diese Kombination durch ein Übereinanderschichten von zwei keramischen Schichten mit etwas unterschiedlicher Zusammensetzung erreicht werden.

Vorteilhafte Ausgestaltungen des erfindungsgemäßen Sensors gehen aus den Unteransprüchen hervor.

Zur weiteren Erläuterung der Erfindung wird nachfolgend auf die Zeichnung Bezug genommen, in deren Figur 1 schematisch ein magnetoresistiver Sensor nach der Erfindung veranschaulicht ist. Figur 2 zeigt in einem Diagramm die Temperaturabhängigkeit des elektrischen Widerstandes und des magnetoresistiven Effektes von zwei verschiedenen Materialien für einen solchen Sensor. Aus dem Diagramm der Figur 3 ist die Temperaturabhängigkeit des elektrischen Widerstandes und des magnetoresistiven Effektes eines erfindungsgemäßen Sensors zu entnehmen. Die Figuren 4 bis 6 zeigen jeweils in einem Diagramm die Temperaturabhängigkeit des elektrischen Widerstandes bzw. des spezifischen Widerstandes von weiteren für einen erfindungsgemäßen Sensor geeigneten Materialien.

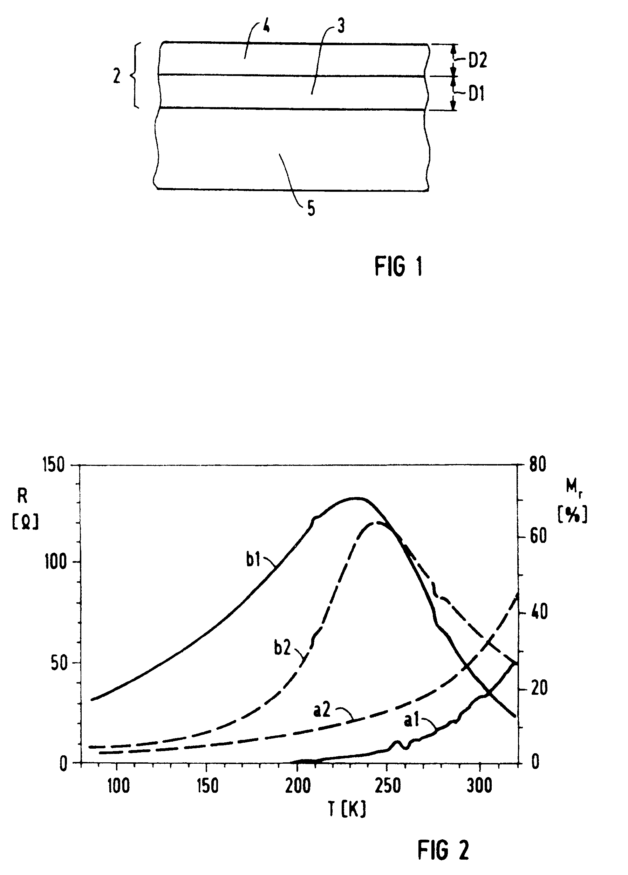

Der erfindungsgemäße Sensor soll ein Schichtensystem mit mehreren Schichten aufweisen, von denen mindestens einige aus Sensormaterialien mit unterschiedlicher Zusammensetzung bestehen. Der Sensor kann z.B. ein Schichtensystem mit mehr als zwei Schichten enthalten, wobei alternierend Schichten mit verschiedener Zusammensetzung übereinander liegen. Gemäß dem in Figur 1 gezeigten Querschnitt sei als einfachste Ausführungsform eines Schichtensystems 2 ein System aus zwei Schichten 3 und 4 auf einem Substrat 5 angenommen. Die Dicken D1 und D2 der Schichten 3 und 4 können dabei gleich groß oder gegebenenfalls auch verschieden sein und liegen im allgemeinen zwischen 10 nm und 10 $\mu$m. Für die Sensormaterialien dieser Schichten 3 und 4 sollen unterschiedliche Zusammensetzungen gewählt sein, die auf dem gemeinsamen System $(A1)_{1-x}$-$(A2)_x MnO_z$ basieren. Hierbei handelt es sich bei der Komponente A1 um Y oder ein Lanthanid wie z.B. La, Pr, Nd, Sm, Eu oder Dy. Die Komponente A2 soll aus der Gruppe der Erdalkalimetalle, insbesondere Mg, Ca, Sr, Ba oder aus Pb, ausgewählt sein. Die einzelnen Anteile der Komponenten sind dabei so zu wählen, daß gilt:

$0{,}1 \leq x \leq 0{,}9$, vorzugsweise $0{,}25 \leq x \leq 0{,}75$.

und

$2{,}0 \leq z \leq 3{,}5$, vorzugsweise $z \approx 3$.

Die beiden Komponenten A1 und A2 sollen dabei jeweils mindestens ein Element aus der jeweiligen Elementengruppe aufweisen. Ferner kann auch die Mn-Komponente jeder Schicht bis zu 35 Atom-% durch ein anderes der genannten Metalle ersetzt sein. Darüber hinaus kann die angegebene Zusammensetzung noch minimale Verunreinigungen mit jeweils unter 0,5 Atom-% pro Verunreinigungselement enthalten. Ausführungsbeispiele für entsprechende Materialien sind demnach $La_{0{,}67}Ba_{0{,}33}MnO_3$ oder $Pr_{0{,}5}Sr_{0{,}5}MnO_3$ oder $Nd_{0{,}33}Ca_{0{,}67}MnO_3$ oder $(Dy_{0{,}67}Mg_{0{,}33})(Mn_{0{,}8}Cu_{0{,}2})$-$O_{2{,}9}$. Alle diese Materialien haben eine perowskitähnliche Kristallstruktur und zeichnen sich durch einen erhöhten magnetoresistiven Effekt $M_r$ von insbesondere über 10 %, vorzugsweise über 50 % aus. Der Effekt liegt damit deutlich höher als bei bekannten Cu/Co-Multilagensystemen.

Schichten aus dem erfindungsgemäßen Material können beispielsweise durch Sputter- oder spezielle Aufdampfprozesse hergestellt werden. Besonders geeignet ist auch die Herstellung einer Schicht mittels Laserverdampfens, wie es zur Herstellung von metalloxidischen Supraleitermaterialien mit Sprungtemperaturen $T_c$ von insbesondere über 77 K her bekannt ist (vgl. z.B. "Appl. Phys. Lett.", Vol. 53, No. 16, 17.10.1988, Seiten 1557 bis 1559). Entsprechende Schichten aus dem erfindungsgemäßen Sensormaterial werden vorteilhaft auf Substraten abgeschieden, deren jeweilige kristalline Einheitszelle an die Einheitszelle des Sensormaterials angepaßte Maße hat.Besonders geeignet sind deshalb Substratmaterialien, die ebenfalls perowskitähnliche Kristallstruktur haben. Entsprechende Ausführungsbeispiele sind $SrTiO_3$, MgO, $LaAlO_3$, $NdGaO_3$, $MgAl_2O_4$ oder Y-stabilisiertes $ZrO_2$ (Abkürzung: YSZ). Daneben sind aber auch Si-Substrate geeignet, die mit einer speziellen Zwischenschicht, einer sogenannten "buffer layer", überzogen sind. Derartige Zwischenschichten sind ebenfalls bei der Abscheidung von Hoch-$T_c$-Supraleitermaterialien bekannt. Ein Beispiel ist das YSZ.

Ein konkretes Ausführungsbeispiel für ein in Figur 1 im Querschnitt veranschaulichtes Zweischichtensystem 2 sei die Abscheidung von zwei Schichten 3 und 4 auf Basis des Stoffsystems La-Sr-Mn-O auf einem $SrTiO_3$-Substrat 5 ausgewählt. Dabei soll die Schicht 3 eine Zusammensetzung $La_{0{,}7}Sr_{0{,}3}MnO_3$ und die Schicht 4 eine Zusammensetzung $La_{0{,}6}Sr_{0{,}4}MnO_3$ haben. Als Abscheidungsverfahren ist vorzugsweise ein Laser-Verdampfen (Laser-Ablation) aus einem jeweils entsprechenden Targetmaterial vorgesehen (vgl. die genannte Literaturstelle aus "Appl. Phys. Lett." 53 oder die DE-PS 38 16 192). Gegebenenfalls kann man das $SrTiO_3$-Substrat 5 bezüglich des Teilchenstroms aus dem jeweils laserablatierten Targetmaterial so anordnen, daß die Normale auf der zu beschichtenden Fläche bzw. Flachseite mindestens annähernd senkrecht bezüglich der Ausbreitungsrichtung des Teilchenstromes ausgerichtet ist (sogenannte "Off-axis-Abscheidung", vgl. z.B. "Appl. Phys. Lett.", Vol. 61, No. 26, 28.12.1992, Seiten 3177 bis 3180). Zur Abscheidung muß in einer geeigneten Beschichtungskammer ein Partialdruck mindestens eines an sich beliebigen Gases zwischen $10^{-3}$ mbar und 100 mbar eingestellt werden. Vorteilhaft wird für die Abscheidung des jeweiligen Schichtmaterials Sauerstoff mit einem verhältnismäßig hohen Partialdruck zwischen 0,2 mbar und 0,6 mbar vorgesehen. Dies ist insbesondere dann erforderlich, wenn von einem sauerstofffreien Targetmaterial ausgegangen wird. Außerdem ist es vorteilhaft, wenn am Substrat 5 eine Temperatur zwischen 400 °C und 1000 °C eingehalten wird. Gegebenenfalls kann aber auch auf eine derartige Aufheizung des Substrates verzichtet werden; oder es ist sogar eine Kühlung während des Beschichtungsvorganges bis auf eine Temperatur unter 20 K möglich.

Zu Vergleichszwecken wurde zunächst auf getrennten $SrTiO_3$-Substraten jeweils eine 300 nm dicke Schicht aus $La_{0{,}7}Sr_{0{,}3}MnO_3$ bzw. aus $La_{0{,}6}Sr_{0{,}4}MnO_3$ aufgebracht. Das Diagramm der Figur 2 zeigt die Temperaturabhängigkeit des elektrischen Widerstandes bzw. des magnetoresistiven Effektes dieser beiden Schichten. In dem Diagramm ist in Abszissenrichtung die Temperatur T [in K] aufgetragen. Auf der linken Ordinate ist der elektrische Widerstand R [in $\Omega$] und auf der rechten Ordinate ist der magnetoresistive Effekt $M_r$ [in %] aufgetragen, wobei $M_r = [R(0) - R(5T)]/R(0)$ zugrundegelegt wurde.Die durchgezogenen Kurven a1 und b1 zeigen den magnetoresistiven Effekt $M_r$, während die gestrichelten Kurven a2 und b2 den elektrischen Widerstand R wiedergeben. Die Kurven a1 und a2 beziehen sich dabei auf das Material $La_{0{,}7}Sr_{0{,}3}MnO_3$, während den Kurven b1 und b2 das Material $La_{0{,}6}Sr_{0{,}4}MnO_3$ zugrundegelegt ist. Bei einem Vergleich des Verlaufs der Kurven a1 und a2 mit dem Verlauf der Kurven b1 und b2 ist deutlich erkennbar, daß sich für unterschiedlich zusammengesetzte Materialien deutlich verschiedene Temperaturabhängigkeiten ergeben.

Erfindungsgemäß werden deshalb mindestens zwei Schichten 3 und 4 zu einem Schichtsystem 2 (gemäß Figur 1) zusammengesetzt, die innerhalb eines interessierenden Temperaturbereiches unterschiedliche Temperaturabhängigkeiten ihres elektrischen Widerstandes und damit ihres magnetoresistiven Effektes zeigen. Die Zusammensetzungen der einzelnen Schichten sollen dabei so gewählt werden, daß quasi gegenläufige Kurvenverläufe in dem gewählten Temperaturbereich, wie aus Figur 2 ersichtlich, sich bei dem Aufbau des Schichtsystems zumindest teilweise kompensieren. Auf diese Weise läßt sich die Temperaturabhängigkeit des elektrischen Widerstandes bzw. des magnetoresistiven Effektes verringern.

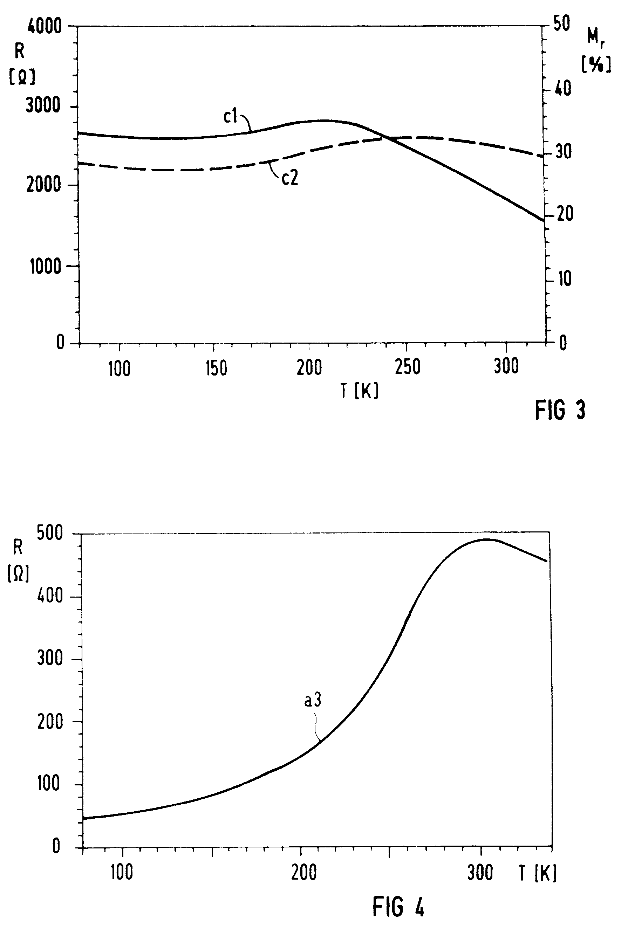

Dieser Sachverhalt ist aus dem Diagramm der Figur 3 abzulesen, für das eine dem Diagramm der Figur 2 entsprechende Darstellung gewählt ist. Die Kurven c1 und c2 ergeben sich dabei für ein Schichtensystem 2 aus einer 150 nm dicken $La_{0,7}Sr_{0,3}MnO_3$-Schicht 3 und einer 150 nm dicken $La_{0,6}Sr_{0,4}MnO_3$-Schicht 4 auf einem $SrTiO_3$-Substrat 5. Die durchgezogene Kurve c1 zeigt die Abhängigkeit des magnetoresistiven Effektes $M_r$ und die gestrichelte Kurve c2 die Abhängigkeit des elektrischen Widerstandes R. Bei einem Vergleich der Diagramme der Figuren 2 und 3 ist ohne weiteres erkennbar, daß die Temperaturabhängigkeit des magnetoresistiven Effektes eines erfindungsgemäßen Sensors mit einem Schichtsystem gegenüber Sensoren mit einzelnen Schichten deutlich vermindert werden kann.

Gemäß dem den Diagrammen zugrundegelegten Ausführungsbeispiel wurde davon ausgegangen, daß die Schichten des Schichtensystems dieselben Komponenten, jedoch eine verschiedene Zusammensetzung aufweisen. Ein entsprechendes Schichtsystem ist vorteilhaft besonders einfach herzustellen. Der erfindungsgemäße Sensor ist jedoch nicht auf ein derartiges Schichtsystem beschränkt. So können gegebenenfalls für benachbarte Schichten eines Schichtsystems auch verschiedene Stoffsysteme zugrundegelegt werden. Ein Beispiel wäre eine erste Schicht aus $La_{0,7}Sr_{0,3}MnO_3$ und eine zweite Schicht aus $La_{0,6}Ba_{0,4}MnO_3$ oder eine erste Schicht aus $Pr_{0,5}Sr_{0,5}MnO_3$ und eine zweite Schicht aus $Nd_{0,3}Ca_{0,7}MnO_3$. Selbstverständlich läßt sich ein Sensor nach der Erfindung auch aus mehr als zwei Schichten aufbauen.

Dem vorstehend beschriebenen Ausführungsbeispiel eines erfindungsgemäßen Sensors wurde ein Schichtsystem mit Schichten aus Stoffsystemen vom Typ $(A1)_{1-x}(A2)_xMnO_z$ zugrundegelegt, deren Komponenten A1 und A2 jeweils ein Element aus den hierzu genannten Gruppen enthalten. Es ist jedoch ebensogut möglich, die für diese Komponenten gewählten Elemente partiell durch andere Elemente aus der jeweiligen Gruppe zu substituieren. Entsprechende Ausführungsbeispiele sind das $(La,Ce)_{0,67}Ba_{0,33}MnO_3$ oder das $Y_{0,67}(Ba,Sr)_{0,33}MnO_3$.

Ferner kann vorteilhaft auch die Mn-Komponente partiell durch ein anderes Element aus der Gruppe der 3d-Elemente (Elemente mit einer Ordnungszahl zwischen 21 und 30 des Periodensystems) oder durch Cu substituiert werden. Hierbei sollte diese Substitution höchstens zu 35 Atom-% erfolgen. Selbstverständlich sind auch in diesem Falle die erwähnten Substitutionen für die Komponenten A1 und A2 zusätzlich möglich.

Der Einfluß einer partiellen Substitution des Mn durch Co ist bei einem Vergleich der Kurve a2 aus dem Diagramm der Figur 2 mit der Kurve a3 aus dem Diagramm der Figur 4 ersichtlich. Für diese Figur 4 wurde eine Figur 2 entsprechende Darstellung gewählt. Die Kurve a3 ergibt sich für ein Material der Zusammensetzung $La_{0,7}Sr_{0,3}Mn_{0,9}Co_{0,1}O_{3+\delta}$ im feldfreien Fall. Der Vergleich der Kurven a2 und a3 belegt die Möglichkeit, mit einer Schicht, deren Mn-Komponente teilweise substituiert ist, zusammen mit einer Schicht ohne Mn-Substitution oder mit anderer Mn-Substitution ein Schichtsystem mit verringerter Temperaturabhängigkeit aufbauen zu können.

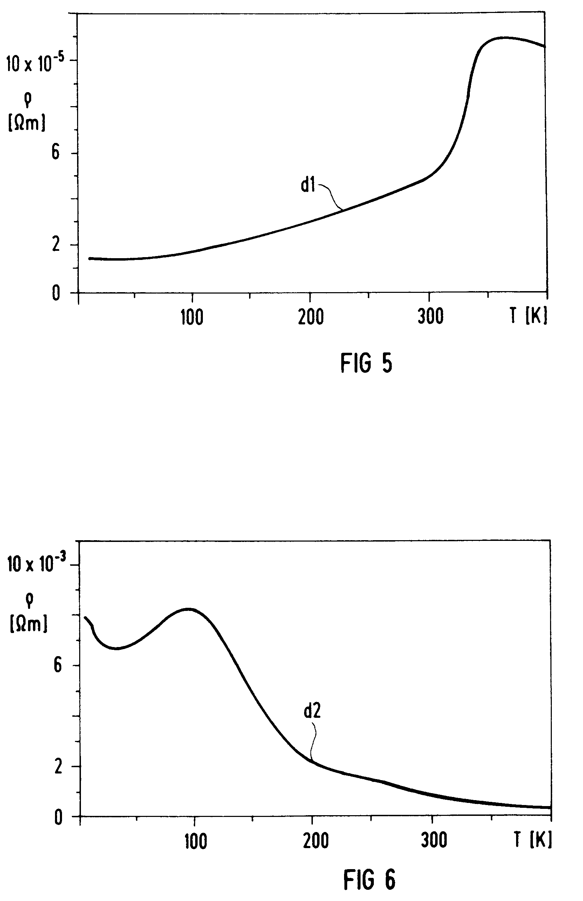

Entsprechendes gilt auch für andere Mn-Substitutionen im Rahmen der genannten Basis-Zusammensetzung. Ein weiteres, demgemäßes Ausführungsbeispiel geht aus den Diagrammen der Figuren 5 und 6 hervor. Für diese Figuren wurde eine Figur 4 weitgehend entsprechende Darstellung gewählt, wobei jedoch in Ordinatenrichtung der spezifische Widerstand $\rho$ [in $\Omega * m$] aufgetragen ist. Der in Figur 5 gezeigten Kurve d1 wurde das Material $La_{0,67}Ba_{0,33}MnO_{3+\delta}$ zugrundegelegt, während sich die Kurve d2 aus Figur 6 für das Material $(La_{0,63}Ba_{0,37})(Mn_{0,9}Cu_{0,1})O_{3+\delta}$ ergibt. Ein Vergleich der beiden Kurven belegt die unterschiedliche Temperaturabhängigkeit der Materialien, so daß sich auch mit diesen ein erfindungsgemäßer Sensor mit einem Schichtsystem mit verringerter Temperaturabhängigkeit erstellen läßt.

Zur Verringerung der Temperaturabhängigkeit ist es neben der Berücksichtigung unterschiedlicher Zusammensetzungen für die Schichten eines Schichtensystems gegebenenfalls zusätzlich noch möglich, auch die Schichtdicken D1 und D2 benachbarter Schichten unterschiedlich zu wählen.

Gemäß den vorstehend erläuterten Ausführungsbeispielen wurde davon ausgegangen, daß das Schichtsystem des erfindungsgemäßen Sensors mindestens zwei diskrete Schichten enthält. Im Falle gleicher Komponenten der Materialien für die mindestens zwei Schichten ist es jedoch auch möglich, statt diskreter Schichten einen einzigen Schichtaufbau in an sich bekannter Weise derart herzustellen, daß man bezüglich mindestens einer der für den Schichtaufbau ausgewählten Materialkomponenten kontinuierlich von einer ersten Konzentration zu einer zweiten Konzentration übergeht. Das Schichtsystem des erfindungsgemäßen Sensors besteht in diesem Falle aus einem Schichtaufbau mit einem Konzentrationsgradienten bezüglich dieser mindestens einen Komponente.

**Patentansprüche**

1. Magnetoresistiver Sensor mit einem Schichtensystem (2) aus mindestens zwei Schichten (3, 4), die jeweils aus einem Sensormaterial bestehen, das eine perowskitähnliche Kristallstruktur besitzt und einen erhöhten magnetoresistiven Effekt zeigt, wobei

    a) das Sensormaterial jeder Schicht (3, 4) eine Zusammensetzung auf Basis von

    $$(A1)_{1-x}(A2)_x MnO_z$$

    aufweist
    - mit der dreiwertigen Komponente A1, ausgewählt aus der Gruppe der Lanthanide einschließlich Lanthan (La) oder aus Yttrium (Y),
    - mit der zweiwertigen Komponente A2, ausgewählt aus der Gruppe der Erdalkalimetalle oder aus Blei (Pb), und
    - mit $0{,}1 \leq x \leq 0{,}9$ sowie $2{,}0 \leq z \leq 3{,}5$, sowie

    b) das Sensormaterial einer zweiten Schicht (4) des Schichtensystems (2) hinsichtlich des Anteils und/oder des Elements von mindestens einer seiner Komponenten A1, A2, Mn und O derart von dem Material einer ersten Schicht (3) des Schichtensystems (2) verschieden ist, daß die Temperaturabhängigkeit des elektrischen Widerstandes (R) des Schichtensystems (2) veringert ist gegenüber der des elektrischen Widerstandes jeder einzelnen Schicht (3, 4).

2. Sensor nach Anspruch 1, **dadurch gekennzeichnet,** daß das Material der ersten Schicht (3) und das Material der zweiten Schicht (4) dieselben Komponenten A1 und A2 aufweisen.

3. Sensor nach Anspruch 1 oder 2, **dadurch ge kennzeichnet,** daß in wenigstens einer Schicht (3, 4) das Mn der Mn-Komponente durch mindestens ein zusätzliches Element A3 aus der Gruppe der Nebengruppenelemente mit 3d-Elektronenkonfiguration oder durch Kupfer (Cu) oder durch Aluminium (Al) teilweise ersetzt ist, so daß diese Komponente die Zusammensetzung

$$Mn_{1-y}(A3)$$

hat
mit $0 \leq y \leq 0{,}35$.

4. Sensor nach einem der Ansprüche 1 bis 3, **dadurch gekennzeichnet,** daß die erste Schicht (3) und die zweite Schicht (4) unterschiedliche Dicken (D1 bzw. D2) haben.

5. Sensor nach einem der Ansprüche 1 bis 4, **dadurch gekennzeichnet,** daß sein Schichtensystem mit mehr als zwei Schichten alternierend aus ersten Schichten (3) und zweiten Schichten (4) aufgebaut ist.

6. Sensor nach Anspruch 2, **dadurch gekenn zeichnet,** daß die mindestens zwei Schichten des Schichtensystems zu einem einzigen Schichtaufbau mit einem Konzentrationsgradienten bezüglich mindestens einer der Komponenten vereinigt sind.

7. Sensor nach einem der Ansprüche 1 bis 6, **dadurch gekennzeichnet,** daß das Schichtensystem (2) auf einem Substrat (5) aus einem Material abgeschieden ist, welches eine perowskitähnliche Kristallstruktur aufweist.

FIG 1

FIG 2

FIG 3

FIG 4

FIG 5

FIG 6

Europäisches Patentamt

**EUROPÄISCHER RECHERCHENBERICHT**

Nummer der Anmeldung

EP 94 11 4629

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG |
|---|---|---|---|
| P,A | PHYSICAL REVIEW LETTERS, 4 OCT. 1993, USA, VOL. 71, NR. 14, ISSN 0031-9007, VON HELMOLT R ET AL 'Giant negative magnetoresistance in perovskitelike La/sub 2/3/Ba/sub 1/3/MnO/sub x/ ferromagnetic films' * das ganze Dokument * --- | 1 | H01L43/10 |
| D,A | DE-A-43 10 318 (SIEMENS AG ) 6.Oktober 1994 * das ganze Dokument * ----- | 1 | |
| | | | **RECHERCHIERTE SACHGEBIETE (Int.Cl.6)** |
| | | | H01L |

Der vorliegende Recherchenbericht wurde für alle Patentansprüche erstellt

| Recherchenort | Abschlußdatum der Recherche | Prüfer |
|---|---|---|
| DEN HAAG | 17.Januar 1995 | Pelsers, L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)